# EUROPEAN PATENT APPLICATION

(11) **EP 4 319 526 A1**
(43) Date of publication of application: **07.02.2024**
(21) Application number: 23171253.0
(22) Date of filing: 03.05.2023
(51) Int. Cl.: H10B 10/00, H01L 29/06, H01L 29/423, H01L 29/66, H01L 29/775, H01L 29/786

(54) **SEMICONDUCTOR DEVICE**

(30) Priority: 02.08.2022 KR 20220096154
(71) Applicant: Samsung Electronics Co., Ltd., Suwon-si, Gyeonggi-do 16677 (KR)
(72) Inventor: LEE, Seunghun, 16677 Suwon-si, Gyeonggi-do (KR); YOON, Seokhyeon, 16677 Suwon-si, Gyeonggi-do (KR); LEE, Kyowook, 16677 Suwon-si, Gyeonggi-do (KR); LEE, Hyejin, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate, a SRAM cell including a pass-gate transistor (TA1), a pull-down transistor (TD1), and a pull-up transistor (TU1) on substrate (101). The SRAM cell includes an active fin (105) extending in a first direction (X), the pass-gate transistor (TA1) and the pull-down transistor (TD1) are disposed adjacent to each other on the active fin (105) in the first direction (X), the pass-gate transistor (TA1) includes first channel layers (140A), a first gate electrode (166A), first source/drain regions (150A, 150S), and first inner spacers (130A), the pull-down transistor (TD1) includes second channel layers (140B), a second gate electrode (166B), second source/drain regions (150B, 150S), and second inner spacers (130B), and one of the first inner spacers (130A) and one of the second inner spacers (130B) are disposed on the same height level and have different thicknesses in the first direction (X).

## Description

### BACKGROUND

The present disclosure relates to a semiconductor device.

Due to characteristics such as miniaturization, multifunctionality, and/or low manufacturing costs, a semiconductor devices are an important element in the electronics industry. Semiconductor devices may be classified into a semiconductor memory device for storing logic data, a semiconductor logic device for processing logic data, and a hybrid semiconductor device including a storage element and a logic element. With the highly developed electronics industry, demands for characteristics of semiconductor devices are increasing. For example, demands for high reliability, high speed, and/or multifunctionality of semiconductor devices are increasing. To satisfy these required characteristics, structures in semiconductor devices are becoming increasingly complex, and semiconductor devices are becoming more and more highly integrated.

### SUMMARY

One or more example embodiments provide a semiconductor device having improved electrical characteristics. According to aspects of an example embodiment, a semiconductor device includes: a substrate; a static random-access memory (SRAM cell) comprising a pass-gate transistor, a pull-down transistor, and a pull-up transistor on the substrate, wherein each of the pass-gate transistor, the pull-down transistor, and the pull-up transistor comprises: an active fin extending in a first direction and protruding upwardly of a device isolation layer; channel layers disposed on the active fin and spaced apart from each other; a gate electrode intersecting the active fin, extending in a second direction, and surrounding the channel layers, the gate electrode comprising inner portions disposed between the channel layers and between the active fin and a lowermost channel layer among the channel layers; a gate dielectric layer between the channel layers and the gate electrode; source/drain regions disposed on the active fin on both sides of the gate electrode, and connected to the channel layers; and inner spacers disposed between the inner portions of the gate electrode and the source/drain regions, wherein the inner spacers of the pass-gate transistor comprise first inner spacers, wherein the inner spacers of the pull-down transistor comprise second inner spacers, wherein at least portions of the first inner spacers disposed on different height levels have different thicknesses in the first direction, wherein at least portions of the second inner spacers disposed on different height levels have different thicknesses in the first direction, and wherein at least one of the first inner spacers and at least one of the second inner spacers are disposed at the same height level and have different thicknesses in the first direction.

According to aspects of an example embodiment, a semiconductor device includes: a substrate; a SRAM cell comprising a pass-gate transistor, a pull-down transistor, and a pull-up transistor on the substrate, wherein the SRAM cell comprises an active fin extending in a first direction, wherein the pass-gate transistor and the pull-down transistor are disposed adjacent to each other on the active fin in the first direction, wherein the pass-gate transistor comprises first channel layers disposed on the active fin, a first gate electrode intersecting the active fin and surrounding the first channel layers, first source/drain regions disposed on the active fin on both sides of the first gate electrode, wherein the pass-gate transistor further comprises first inner spacers contacting respective lower surfaces of the first channel layers, contacting the first source/drain regions, and wherein the first inner spacers are disposed on both sides of the first gate electrode, wherein the pull-down transistor comprises second channel layers disposed on the active fin, a second gate electrode intersecting the active fin and surrounding the second channel layers, second source/drain regions disposed on the active fin on both sides of the second gate electrode, wherein the pull-down transistor further comprises second inner spacers contacting respective lower surfaces of the second channel layers, contacting the second source/drain regions, and wherein the second inner spacers are disposed on both sides of the second gate electrode, and wherein at least one of the first inner spacers and at least one of the second inner spacers are disposed on the same height level and have different thicknesses in the first direction.

According to aspects of an example embodiment, a semiconductor device includes: a substrate; a SRAM cell comprising a pass-gate transistor, a pull-down transistor, and a pull-up transistor on the substrate, wherein the SRAM cell comprises an active fin extending in a first direction, wherein the pass-gate transistor and the pull-down transistor are disposed adjacent to each other in the first direction on the active fin, wherein the pass-gate transistor comprises first channel layers on the active fin, a first gate electrode intersecting the active fin and surrounding the first channel layers, a first gate dielectric layer between the first channel layers and the first gate electrode, and first source/drain regions disposed on the active fin on both sides of the first gate electrode, wherein the pull-down transistor comprises second channel layers on the active fin, a second gate electrode intersecting the active fin and surrounding the second channel layers, a second gate dielectric layer between the second channel layers and the second gate electrode, and second source/drain regions disposed on the active fin on both sides of the second gate electrode, wherein the first gate electrode comprises first inner portions between the first inner spacers, wherein the second gate electrode comprises second inner portions between the second inner spacers, and wherein at least one of the first inner portions and at least one of the second inner portions are disposed on the same height level as each other and have different gate lengths in the first direction.

### BRIEF DESCRIPTION OF DRAWINGS

The above and other aspects and features will be more apparent from the following description of example embodiments, taken in conjunction with the accompanying drawings, in which:
FIG. 1 is an equivalent circuit diagram of a SRAM cell according to example embodiments;
FIG. 2 is a plan view schematically illustrating a semiconductor device according to example embodiments;
FIG. 3A is a cross-sectional view schematically illustrating a semiconductor device according to example embodiments;
FIG. 3B is a partially enlarged view illustrating an enlarged area 'A' of FIG. 3A;
FIG. 3C is a cross-sectional view schematically illustrating a semiconductor device according to example embodiments;
FIGS. 4 to 11 are views illustrating a process sequence to describe a method of manufacturing a semiconductor device according to example embodiments; and
FIGS. 12 to 15 are views illustrating a process sequence to describe a method of manufacturing a semiconductor device according to example embodiments.

### DETAILED DESCRIPTION

Example embodiments will be described more fully with reference to the accompanying drawings, in which example embodiments are shown. Embodiments described herein are provided as examples, and thus, the present disclosure is not limited thereto, and may be realized in various other forms. Each example embodiment provided in the following description is not excluded from being associated with one or more features of another example or another example embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

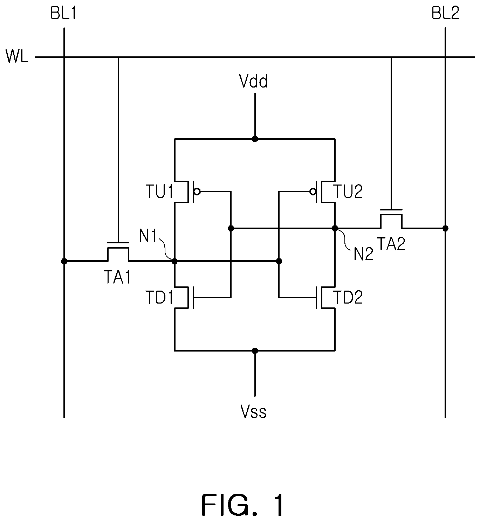

FIG. 1 is an equivalent circuit diagram of an SRAM cell according to example embodiments.

Referring to FIG. 1, an SRAM cell according to example embodiments may include a first pull-up transistor TU1, a first pull-down transistor TD1, a second pull-up transistor TU2, a second pull-down transistor TD2, a first pass-gate transistor TA1, and a second pass-gate transistor TA2. The first and second pull-up transistors TU1 and TU2 may be PMOS transistors. The first and second pull-down transistors TD1 and TD2 and the first and second pass-gate transistors TA1 and TA2 may be NMOS transistors.

A first source/drain of the first pull-up transistor TU1 and a first source/drain of the first pull-down transistor TD1 may be connected to the first node N1. A second source/drain of the first pull-up transistor TU1 may be connected to a power line VDD, and a second source/drain of the first pull-down transistor TD1 may be connected to a ground line VSS. have. A gate of the first pull-up transistor TU1 and a gate of the first pull-down transistor TD1 may be electrically connected to each other. The first pull-up transistor TU1 and the first pull-down transistor TD1 may constitute a first inverter. The gates connected to each other of the first pull-up and first pull-down transistors TU1 and TD1 may correspond to the input terminal of the first inverter, and the first node N1 may correspond to the output terminal of the first inverter.

The first source/drain of the second pull-up transistor TU2 and the first source/drain of the second pull-down transistor TD2 may be connected to the second node N2. A second source/drain of the second pull-up transistor TU2 may be connected to a power line VDD, and a second source/drain of the second pull-down transistor TD2 may be connected to a ground line VSS. A gate of the second pull-up transistor TU2 and a gate of the second pull-down transistor TD2 may be electrically connected to each other. Accordingly, the second pull-up transistor TU2 and the second pull-down transistor TD2 may constitute a second inverter. The gates connected to each other of the second pull-up and second pull-down transistors TU2 and TD2 may correspond to the input terminal of the second inverter, and the second node N2 may correspond to the output terminal of the second inverter.

The first and second inverters may be combined to form a latch structure. For example, gates of the first pull-up and first pull-down transistors TU1 and TD1 may be electrically connected to the second node N2, and gates of the second pull-up and second pull-down transistors TU2 and TD2 may be electrically connected to the first node N1. A first source/drain of the first pass-gate transistor TA1 may be connected to the first node N1, and a second source/drain of the first pass-gate transistor TA1 may be connected to a first bit line BL1. A first source/drain of the second pass-gate transistor TA2 may be connected to the second node N2, and a second source/drain of the second pass-gate transistor TA2 may be connected to a second bit line BL2. Gates of the first and second pass-gate transistors TA1 and TA2 may be electrically connected to the word line WL. Accordingly, the SRAM cell according to the example embodiments may be implemented.

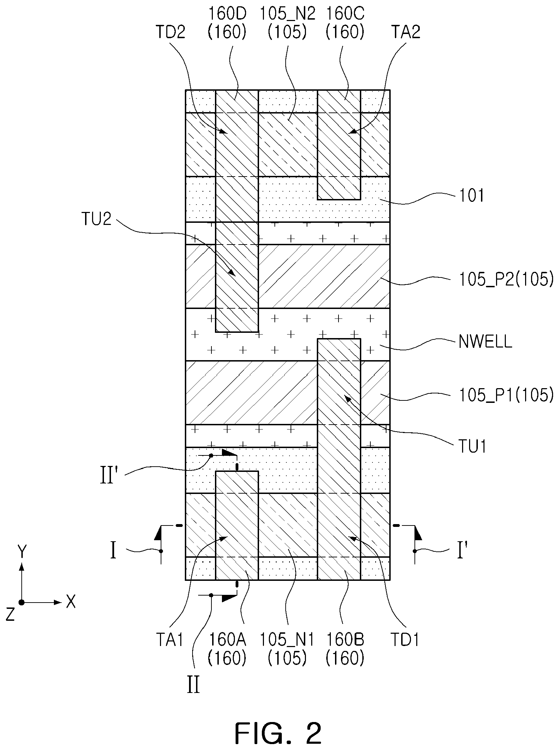

FIG. 2 is a plan view schematically illustrating a semiconductor device according to example embodiments. FIG. 2 is a plan view of an SRAM cell according to the circuit diagram of FIG. 1 implemented on a substrate 101.

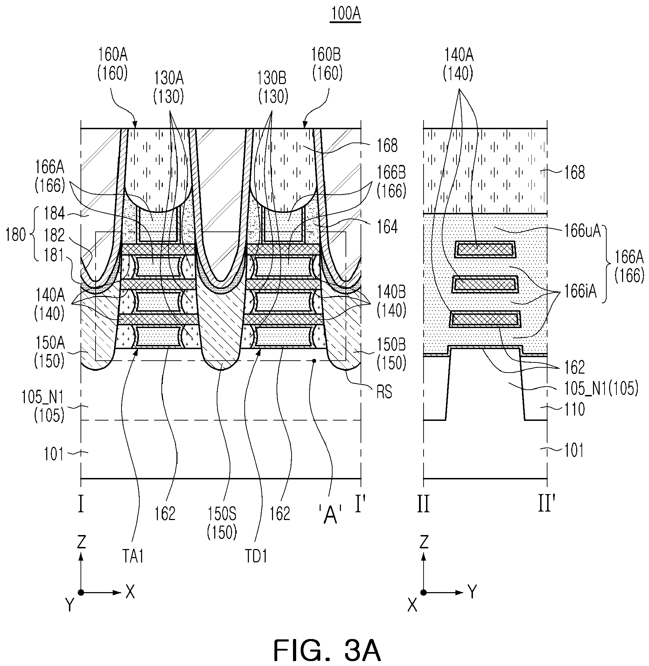

FIG. 3A is a cross-sectional view schematically illustrating a semiconductor device according to example embodiments. FIG. 3A shows cross-sections of the semiconductor device of FIG. 2 taken along cutting lines I-I' and II-II'.

Referring to FIGS. 2 and 3A, a semiconductor device 100A may include an SRAM cell that includes a first pull-up transistor TU1, a first pull-down transistor TD1, a second pull-up transistor TU2, a second pull-down transistor TD2, a first pass-gate transistor TA1, and a second pass-gate transistor TA2. The first pass-gate transistor TA1 and the first pull-down transistor TD1 may be disposed adjacent to each other in a first direction, the X-direction, and the second pass-gate transistor TA2 and the second pull-down transistor TD2 may be disposed adjacent to each other in the X-direction.

Each of the transistors constituting the SRAM cell may include an active fin 105, channel layers 140 spaced apart from each other on the active fin 105, a gate structure 160 crossing the active fin 105, source/drain regions 150 disposed on the active fin 105 on both sides of the gate structure 160, and inner spacers 130 in contact with side surfaces of the source/drain regions 150. Although the cross-sectional structures of the first pass-gate transistor TA1 and the first pull-down transistor TD1 are illustrated in FIG. 3A, the second pass-gate transistor TA2 and the second pull-down transistor TD2 may have a structure similar thereto. The first and second pull-up transistors TU1 and TU2 may also have similar structures.

The semiconductor device 100A may further include a device isolation layer 110 defining or defining the active fin 105 in the substrate 101 and contact structures 180 connected to the source/drain regions 150.

In the semiconductor device 100A, the active fin 105 has a fin structure, and at least a portion of the gate structure 160 is formed between the active fin 105 and the channel layers 140, between the channel layers 140, and on the channel layers 140. Accordingly, the semiconductor device 100A may include a multi-bridge channel FET (MBCFET^{™}) formed by the channel layers 140, the source/drain regions 150, and the gate structure 160.

The substrate 101 may include a semiconductor material, for example, a group IV semiconductor, a group III-V compound semiconductor, or a group II-VI compound semiconductor. For example, the group IV semiconductor may include silicon (Si), germanium (Ge), or silicon germanium (SiGe). The substrate 101 may be provided, for example, as a bulk wafer, an epitaxial layer, a silicon on insulator (SOI) layer, a semiconductor on insulator (SeOI) layer, or the like. The substrate 101 may include a doped region such as an N well region NWELL. A first pull-up transistor TU1 and a second pull-up transistor TU2 of the SRAM cell may be provided on the N well region NWELL.

The active fin 105 is defined by the device isolation layer 110 in the substrate 101 and may extend in the X-direction. The active fin 105 may have a structure protruding from the substrate 101 into the device isolation layer 110. The active fin 105 may be formed as a part of the substrate 101, and may include an epitaxial layer grown from the substrate 101. However, respective recessed regions RS may be formed in the active fin 105 on both sides of the gate structure 160, and source/drain regions 150 may be disposed on the recessed regions RS. The active fin 105 may include impurities.

The active fin 105 may include first to fourth active fins 105_N1, 105_N2, 105_P1, and 105_P2. A first pass-gate transistor TA1 and a first pull-down transistor TD1 may be disposed on the first active fin 105_N1. A second pass-gate transistor TA2 and a second pull-down transistor TD2 may be disposed on the second active fin 105_N2. The first pull-up transistor TU1 may be disposed on the third active fin 105_P1, and the second pull-up transistor TU2 may be disposed on the fourth active fin 105_P2. The third and fourth active fins 105_P1 and 105_P2 disposed on the N well region NWELL may include impurities of a conductivity type different from that of the first and second active fins 105_N1 and 105_N2.

The device isolation layer 110 may be formed by, for example, a shallow trench isolation (STI) process. The device isolation layer 110 may be disposed to cover a portion of a side surface of the active fin 105. The device isolation layer 110 may include an insulating material, for example, at least one of silicon oxide, silicon nitride, and silicon oxynitride.

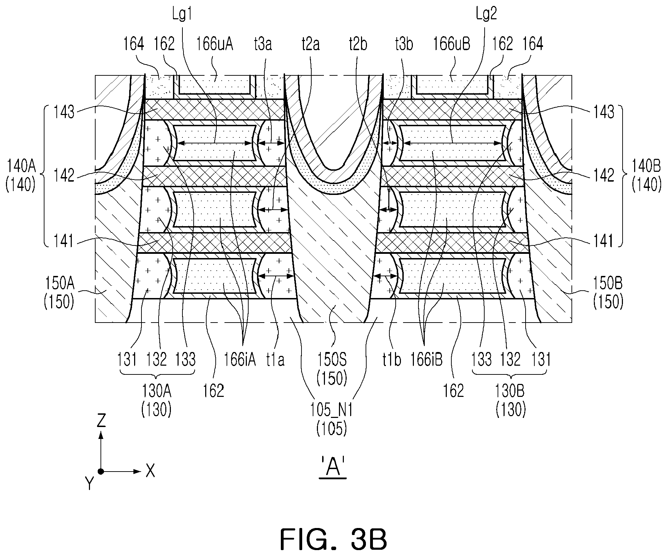

The inner spacers 130 may be disposed between the inner portions of the gate electrode 166 ('166iA' or '166iB' in FIG. 3B) and the source/drain regions 150. The inner spacers 130 may be disposed on both opposite sides of the gate electrode 166, with the gate electrode 166 interposed therebetween. The inner spacers 130 may contact the lower surface of each of the channel layers 140 and the source/drain regions 150. The inner spacers 130 may have side surfaces that are curved convex toward the inner portions of the gate electrode 166 ('166iA' or '166iB' in FIG. 3B). The inner spacers 130 may include at least one of SiN, SiCN, SiOCN, SiBCN, or SiBN. The inner spacers 130 may include first inner spacers 130A of the first pass-gate transistor TA1 and second inner spacers 130B of the first pull-down transistor TD1. The first and second inner spacers 130A and 130B will be further described with reference to FIG. 3B below.

The channel layers 140 may be disposed on the active fin 105 and may be spaced apart from each other in a direction perpendicular to the top surface of the active fin 105, for example, in the Z-direction. The number of layers constituting the channel layers 140 is not limited to those illustrated and may be variously changed according to example embodiments. The channel layers 140 may be surrounded by the gate electrode 166. The channel layers 140 may include a semiconductor material, for example, at least one of silicon (Si), silicon-germanium (SiGe), or germanium (Ge).

The channel layers 140 may include first channel layers 140A of the first pass-gate transistor TA1 and second channel layers 140B of the first pull-down transistor TD1. A shared source/drain region 150S among the source/drain regions 150 may be disposed between the first channel layers 140A and the second channel layers 140B.

The source/drain regions 150 may be disposed on the active fin 105 on both sides of the gate structure 160. The source/drain regions 150 may be connected to side surfaces of each of the channel layers 140. The source/drain regions 150 may be disposed on the recess region RS in which the upper portion of the active fin 105 is recessed. For example, the source/drain regions 150 may project into a recess of the active fin 105 below the top of the active fin 105. The lower ends of the source/drain regions 150 may be located at a level lower than the lowermost inner spacer 130 among the inner spacers 130.

The source/drain regions 150 may serve as a source region or a drain region of the transistor, respectively. The source/drain regions 150 may include a semiconductor layer including silicon, and may be formed of an epitaxial layer. The source/drain regions 150 may include the same or different types of impurities depending on the type of the transistor provided on the substrate 101. For example, the source/drain regions 150 provided on the first and second active fins 105_N1 and 105_N2 may include N-type doped silicon, and the third and fourth active fins 105_P1 and 105_P2 may include P-type doped silicon germanium. Each of the source/drain regions 150 may include a plurality of regions including different concentrations of an element and/or a doping element.

The source/drain regions 150 may include first source/drain regions 150A and shared source/drain regions 150S of the first pass-gate transistor TA1 and second source/drain regions 150B and shared source/drain regions 150S of the first pull-down transistor TD1. One shared source/drain region 150S of the first source/drain regions 150A and 150S and one shared source/drain region 150S of the second source/drain regions 150B and 150S may be a shared source/drain region 150S shared by the first pass-gate transistor TA1 and the first pull-down transistor TD1 with each other, but the present exemplary embodiment is not limited thereto. The shared source/drain region 150S may be in contact with the first channel layers 140A and the second channel layers 140B. The shared source/drain region 150S may contact the first inner spacers 130A and the second inner spacers 130B.

The gate structure 160 may cross the active fin 105 and extend in the Y-direction. The gate structure 160 may surround the channel layers 140. A channel region of the transistor may be formed in the channel layers 140 surrounded by the gate structure 160. The gate structure 160 may include a gate dielectric layer 162, a gate spacer 164, a gate electrode 166, and a gate capping layer 168.

The gate dielectric layer 162 may be disposed between the active fin 105 and the gate electrode 166 and between the channel layers 140 and the gate electrode 166. The gate dielectric layer 162 may be disposed to surround all surfaces except the top surface of the gate electrode 166. The gate dielectric layer 162 may conformally cover an inner surface of the gate spacer 164. The gate dielectric layer 162 may be disposed together with the gate electrode 166 to fill a space between the channel layers 140, for example. The thickness of the gate dielectric layer 162 of the first pass-gate transistor TA1 may be substantially the same as the thickness of the gate dielectric layer 162 of the first pull-down transistor TD1.

The gate dielectric layer 162 may include an oxide, nitride, or high-k material. The high-k material may refer to a dielectric material having a higher dielectric constant than that of a silicon oxide layer (SiOz). The high dielectric constant material may be, for example, one or more of aluminum oxide (Al₂O₃), tantalum oxide (Ta₂O₃), titanium oxide (TiO₂), yttrium oxide (Y2O3), zirconium oxide (ZrO₂), zirconium silicon oxide (ZrSiₓO_{y}), hafnium oxide (HfO2), hafnium silicon oxide (HfSixOy), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

The gate electrode 166 may be disposed on the gate dielectric layer 162. The gate electrode 166 fills between the channel layers 140 on the active fin 105, and may be disposed on the channel layers 140. The gate electrode 166 may include a conductive material, for example, a material such as TiN, TiC, TiAl, TiAlN, TiSiN, TiAlC, TaN, TaC, TaAl, TaAlN, TaAlN, WN, Al, W, Mo, and the like. The gate electrode 166 may include, for example, a semiconductor material such as doped polysilicon. In one example, the gate electrode 166 may be composed of two or more multilayer structures.

The gate spacers 164 may be disposed on both of opposite sides of the gate electrode 166. The gate spacers 164 may insulate the source/drain regions 150 from the gate electrode 166. Each of the gate spacers 164 may have a multilayer structure. The gate spacers 164 may include at least one of silicon oxide, silicon nitride, and silicon oxynitride.

The gate capping layer 168 may be disposed on the gate electrode 166. The gate capping layer 168 may be disposed to extend in the Y-direction along the top surface of the gate electrode 166. The gate capping layer 168 may include at least one of silicon oxide, silicon nitride, silicon carbonate, silicon carbonitride, or silicon oxynitride. The gate capping layers 168 may self-align a contact hole for forming the contact structure 180 between the gate capping layers 168.

The gate structure 160 may include a first gate structure 160A including a first gate electrode 166A of the first pass-gate transistor TA1, and a second gate electrode 166B including a second gate electrode 166B of the first pull-down transistor TD1.

The contact structures 180 may be disposed on both sides of the gate structure 160 to extend along the Z-direction to be connected to the source/drain regions 150. The contact structures 180 may have sides that are inclined so that the width of the lower part is narrower than the width of the upper part, but is not limited thereto. The contact structure 180 may include a metal-semiconductor compound layer 181, a barrier layer 182, and a plug layer 184.

The metal-semiconductor compound layer 181 may include, for example, metal silicide, metal germanide, or metal silicide-germanide. In the metal-semiconductor compound layer 181, the metal may be titanium (Ti), nickel (Ni), tantalum (Ta), cobalt (Co), or tungsten (W), and the semiconductor may be silicon (Si), germanium (Ge) or silicon germanium (SiGe). For example, the metal-semiconductor compound layer 181 may include at least one of cobalt silicide (CoSi), titanium silicide (TiSi), nickel silicide (NiSi), or tungsten silicide (WSi).

The barrier layer 182 may surround a bottom surface and sides of the plug layer 184. The barrier layer 182 may include a metal nitride, for example, at least one of titanium nitride (TiN), tantalum nitride (TaN), or tungsten nitride (WN). The plug layer 184 may include at least one of a metal material, for example, aluminum (Al), copper (Cu), tungsten (W), cobalt (Co), ruthenium (Ru), or molybdenum (Mo). In an example embodiment, the barrier layer 182 may be omitted.

FIG. 3B is a partially enlarged view showing an enlarged area 'A' of FIG. 3A.

Referring to FIG. 3B, one of the first inner spacers 130A of the first pass-gate transistor TA1 and one of the second inner spacers 130B of the first pull-down transistor TD1 may be disposed on the same height level as each other and may have different thicknesses in the X-direction.

The first inner spacers 130A of the first pass-gate transistor TA1 may include first to third layers 131, 132, and 133 disposed on different height levels. At least some of the first to third layers 131, 132, and 133 of the first inner spacers 130A may have different thicknesses in the X-direction. The first to third layers 131, 132, and 133 of the first inner spacers 130A have first to third thicknesses t1a, t2a and t3a in the X-direction, respectively. According to the example embodiment, the third thickness t3a may be, for example, less than the second thickness t2a, and the second thickness t2a may be less than the first thickness t1a. Accordingly, for example, the first layer 131 of the example embodiment may be on a different height level than the second layer 132 and may have a different thickness than the second layer 132 in the X-direction. Similarly, the second layer 132 of the example embodiment may be on a different height level than the third layer 133 and may have a different thickness than the third layer 133 in the X-direction. The third layer 133 of the first inner spacers 130A may be in contact with a lower surface of the third layer 143 of the first channel layers 140A.

The second inner spacers 130B of the first pull-down transistor TD1 may include first to third layers 131, 132, and 133 disposed on different height levels. At least some of the first to third layers 131, 132, and 133 of the second inner spacers 130B may have different thicknesses in the X-direction. The first to third layers 131, 132, and 133 of the second inner spacers 130B have fourth to sixth thicknesses tib, t2b and t3b in the X-direction, respectively, and the sixth thickness t3b may be less than the fifth thickness t2b, and the fifth thickness t2b may be less than the fourth thickness t1b. Accordingly, for example, the first layer 131 of the example embodiment may be on a different height level than the second layer 132 and may have a different thickness than the second layer 132 in the X-direction. Similarly, the second layer 132 of the example embodiment may be on a different height level than the third layer 133 and may have a different thickness than the third layer 133 in the X-direction. The third layer 133 of the second inner spacers 130B may contact the lower surface of the third layer 143 of the second channel layers 140B.

The fourth thickness t1b may be smaller than the first thickness t1a, the fifth thickness t2b may be smaller than the second thickness t2a, and the sixth thickness t3b may be smaller than the third thickness t3a.

The first gate electrode 166A of the first pass-gate transistor TA1 may include first inner portions 166iA and a first upper portion 166uA. The first inner portions 166iA may be disposed between the first active fin 105_N1 and the first layer 141 of the first channel layers 140A, between the first layer 141 of the first channel layers 140A and the second layer 142 of the first channel layers 140A and between the second layer 142 and the third layer 143 of the first channel layers 140A. The first upper portion 166uA may be disposed on the third layer 143 of the first channel layers 140A. The first inner portions 166iA may be disposed between the first inner spacers 130A.

The second gate electrode 166B of the first pull-down transistor TD1 may include second inner portions 166iB and a second upper portion 166uB. The second inner portions 166iB may be disposed between the first active fin 105_N1 and the first layer 141 of the second channel layers 140B, between the first layer 141 and the second layer 142 of the second channel layers 140B and between the second layer 142 and the third layer 143 of the second channel layers 140B. The second upper portion 166uB may be disposed on the third layer 143 of the second channel layers 140B. The second inner portions 166iB may be disposed between the second inner spacers 130B.

One of the first inner portions 166iA and one of the second inner portions 166iB may be disposed at the same height level and may have different gate lengths in the X-direction. For example, at a level between the second layer 142 and the third layer 143, the first inner portion 166iA has a first gate length Lg1 in the X-direction, and the second inner portion 166iB has The second gate length Lg2 may be different from the first gate length Lg1 in the X-direction. In one example, the second gate length Lg2 may be greater than the first gate length Lg1.

In the SRAM cell, a current flowing through the first pull-down transistor TD1 should be greater than a current flowing through the first pass-gate transistor TA1 during operation of the SRAM cell for a stable minimum voltage Vmin. In the SRAM cell, to lower the write minimum voltage Vmin, the current flowing through the first pass-gate transistor TA1 should be greater than the current flowing through the first pull-down transistor TD1 during the operation of the SRAM cell. According to an example embodiment, by forming the thicknesses of the inner spacers 130 to have different thicknesses depending on the transistors, the threshold voltages of the transistors may be fine-tuned by adjusting the gate length. For example, as the gate length of the first pass-gate transistor TA1 decreases, the threshold voltage is lowered to increase the current flowing through the first pass-gate transistor TA1, and therefore, the minimum write voltage Vmin may be lowered during operation of the SRAM cell.

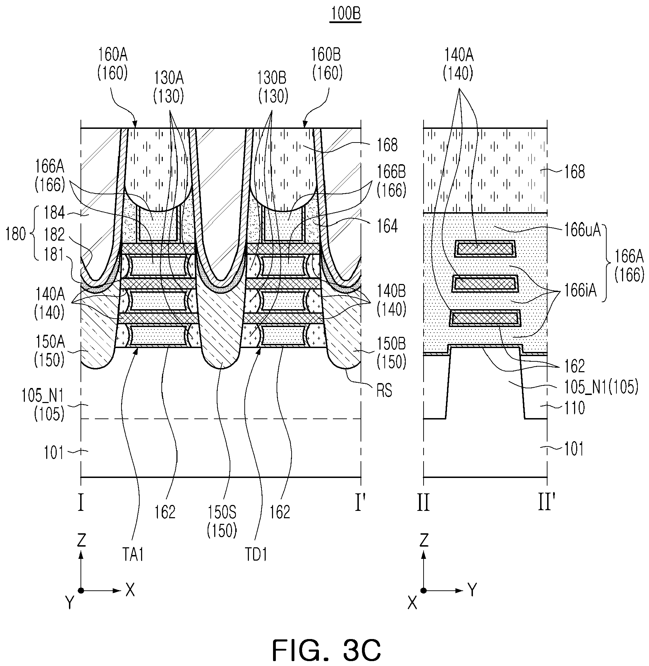

FIG. 3C is a cross-sectional view schematically illustrating a semiconductor device according to example embodiments.

Referring to FIG. 3C, in the semiconductor device 100B, one of the first inner spacers 130A of the first pass-gate transistor TA1 and one of the second inner spacers 130B of the first pull-down transistor TD1 may be disposed at the same height level as each other, and may have different thicknesses in the X-direction. For example, a thickness of one of the first inner spacers 130A may be smaller than a thickness of one of the second inner spacers 130B of the first pull-down transistor TD1. In the example embodiment of FIG. 3C, contrary to that illustrated in FIG. 3B, the fourth thickness t1b may be greater than the first thickness t1a, the fifth thickness t2b may be greater than the second thickness t2a, and the sixth thickness t3b may be greater than the third thickness t3a. Accordingly, as the gate length of the first pull-down transistor TD1 decreases, the threshold voltage is lowered to increase the current flowing through the first pull-down transistor TD1, so that the stable minimum voltage Vmin of the SRAM cell may be obtained.

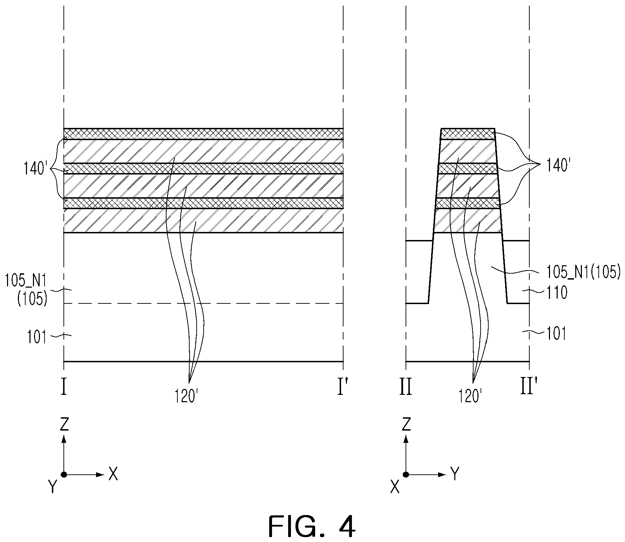

FIGS. 4 to 11 are views illustrating a process sequence to describe a method of manufacturing a semiconductor device according to example embodiments.

Referring to FIG. 4, first semiconductor layers 120' and second semiconductor layers 140' may be formed on a substrate 101. The first semiconductor layers 120' and the second semiconductor layers 140' may be etched to form a line extending in the X-direction.

The first semiconductor layers 120' and the second semiconductor layers 140' may be formed by performing an epitaxial growth process using the substrate 101 as a seed. The number and thickness of the stacking of the first semiconductor layers 120' and the second semiconductor layers 140' may be variously changed in the embodiments. The first semiconductor layers 120' may be layers replaced with the gate dielectric layer 162 and the gate electrode 166 through a subsequent process, as illustrated in FIGS. 3A and 3B.

The first semiconductor layers 120' may be formed of a material having etch selectivity with respect to the second semiconductor layers 140'. The first semiconductor layers 120' may include a material different from that of the second semiconductor layers 140'. For example, the first semiconductor layers 120' may include silicon germanium, and the second semiconductor layers 140' may include silicon.

The substrate 101 may also be partially etched under the first semiconductor layers 120' and the second semiconductor layers 140' to form an active fin 105. The device isolation layer 110 may be formed in the region from which the part of the substrate 101 is removed by burying an insulating material and then recessing the active fin 105 to protrude. The upper surface of the device isolation layer 110 may be formed to be lower than the upper surface of the active fin 105.

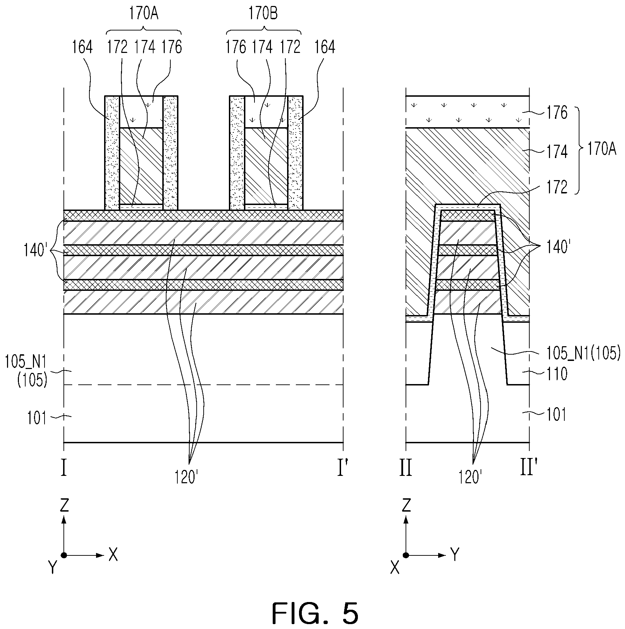

Referring to FIG. 5, sacrificial gate patterns 170A and 170B and gate spacers 164 may be formed.

The sacrificial gate patterns 170A and 170B may be sacrificial patterns formed in a region where the gate dielectric layer 162 and the gate electrode 166 are disposed, as illustrated in FIGS. 3A and 3B through a subsequent process. The sacrificial gate patterns 170A and 170B may include first and second sacrificial gate layers 172 and 174 and a mask 176 sequentially stacked, respectively. The first and second sacrificial gate layers 172 and 174 may be patterned using a mask 176. The first and second sacrificial gate layers 172 and 174 may be an insulating layer and a conductive layer, respectively, but are not limited thereto, and the first and second sacrificial gate layers 172 and 174 may be formed as one layer. For example, the first sacrificial gate layer 172 may include silicon oxide, and the second sacrificial gate layer 174 may include polysilicon. The mask 176 may be formed of a carbon-containing material layer such as an amorphous carbon layer (ACL) or a spin-on hardmask (SOH). The sacrificial gate patterns 170A and 170B may have a line shape that crosses the active fin 105 and extends in one direction, for example, the Y-direction.

Gate spacers 164 may be formed on both sidewalls of each of the sacrificial gate patterns 170A and 170B. The gate spacer 164 layers may be formed by forming a uniform thickness film along the surfaces of the sacrificial gate patterns 170A and 170B, the device isolation layer 110, the first semiconductor layers 120', and the second semiconductor layers 140' and then performing anisotropic etching thereon.

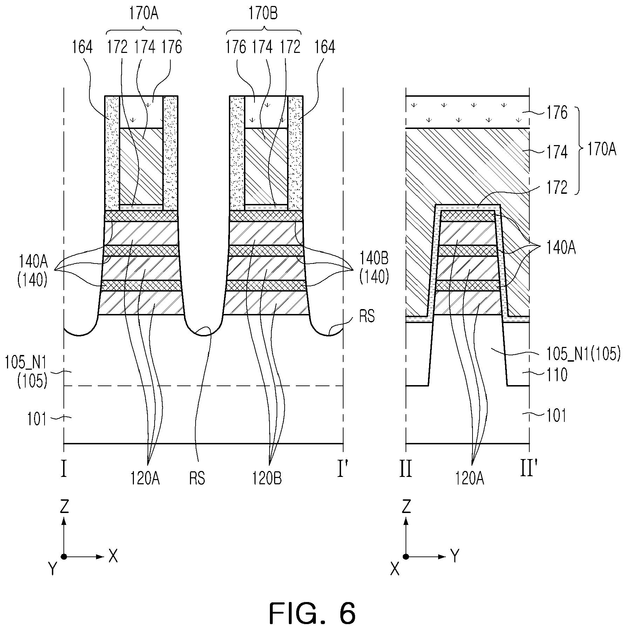

Referring to FIG. 6, the first semiconductor layers 120' and the second semiconductor layers 140' may be etched to form a recess region RS recessing the active fin 105.

The exposed second semiconductor layers 140' and the first semiconductor layers 120' may be removed by using the sacrificial gate patterns 170A and 170B and the gate spacers 164 as etch masks. Accordingly, the second semiconductor layers 140' may have a limited length in the X-direction to form the channel layers 140A and 140B. The first semiconductor layers 120' also have a limited length in the X-direction, so that the sacrificial layers 120A and 120B may be formed.

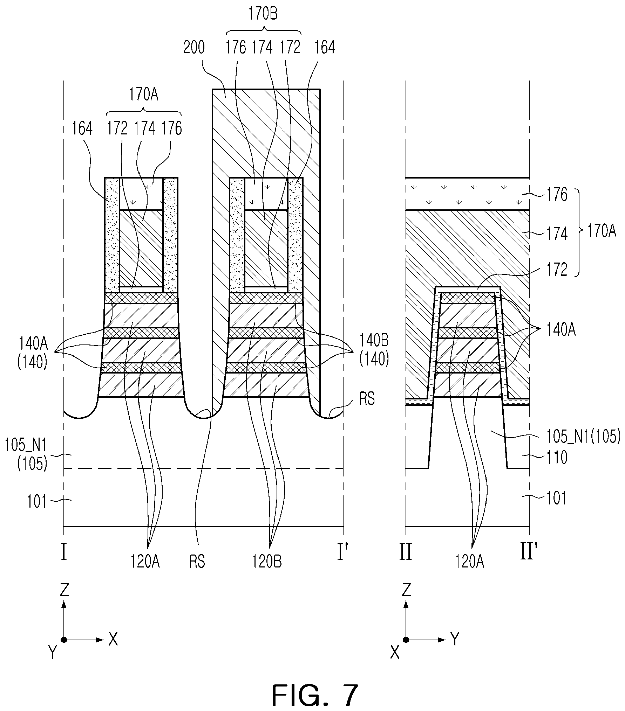

Referring to FIG. 7, the first sacrificial gate pattern 170A is opened, a blocking layer 200 covering the second sacrificial gate pattern 170B is formed, and the first sacrificial layers are formed below the first sacrificial gate pattern 170A. An ion implantation process may be performed in 120A.

A region doped with impurities may be formed in the first sacrificial layers 120A. Accordingly, the exposed ends of the first sacrificial layers 120A may have different etch selectivity from the exposed ends of the second sacrificial layers 120B. The blocking layer 200 may be formed of a single layer or a multiple layer structure of at least one of Bottom Anti-Reflective Coating (BARC), Amorphous Carbon Layer (ACL), Spin on Hardmask (SOH), Spin on Carbon (SOC), or a silicon nitride layer.

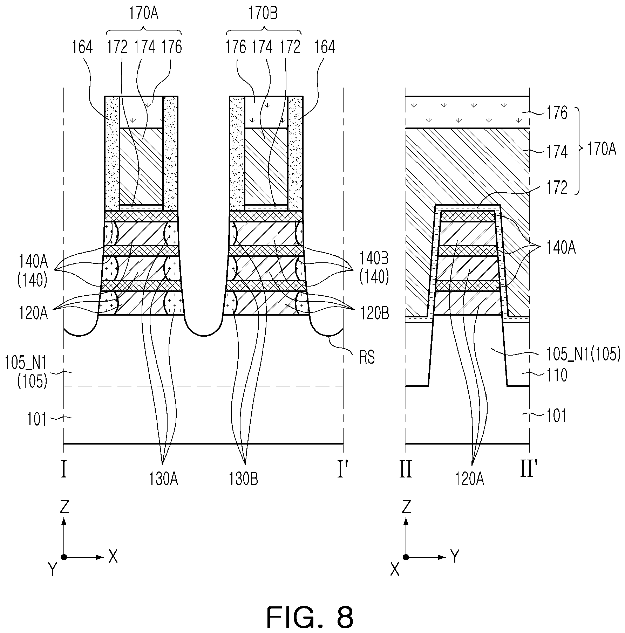

Referring to FIG. 8, the sacrificial layers 120A and 120B may be partially removed from the side surface, and inner spacers 130A and 130B may be formed in regions where the sacrificial layers 120A and 120B are removed.

The inner spacers 130A and 130B may be formed by filling an insulating material in the region from which the sacrificial layers 120A and 120B have been removed and by removing the insulating material deposited outside the channel layers 140A and 140B and below the recess region RS. Since the etching rate of the first sacrificial layers 120A is higher than that of the second sacrificial layers 120B, more of the first sacrificial layers 120A may be removed from the side surface. Accordingly, the first inner spacers 130A may be formed to have a greater thickness in the X-direction than the second inner spacers 130B.

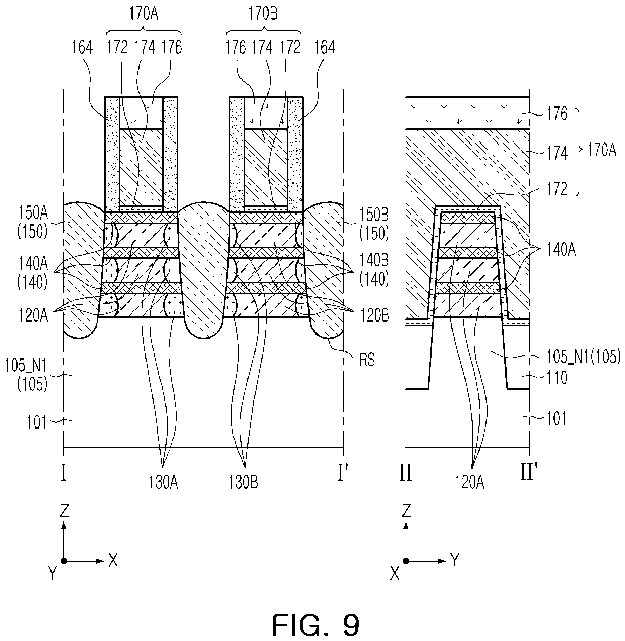

Referring to FIG. 9, source/drain regions 150 may be formed on the active fin 105. The source/drain regions 150 may be formed by performing an epitaxial growth process on the recess region RS. The source/drain regions 150 may be connected to side surfaces of the channel layers 140. The source/drain regions 150 may include impurities through an in-situ doping process.

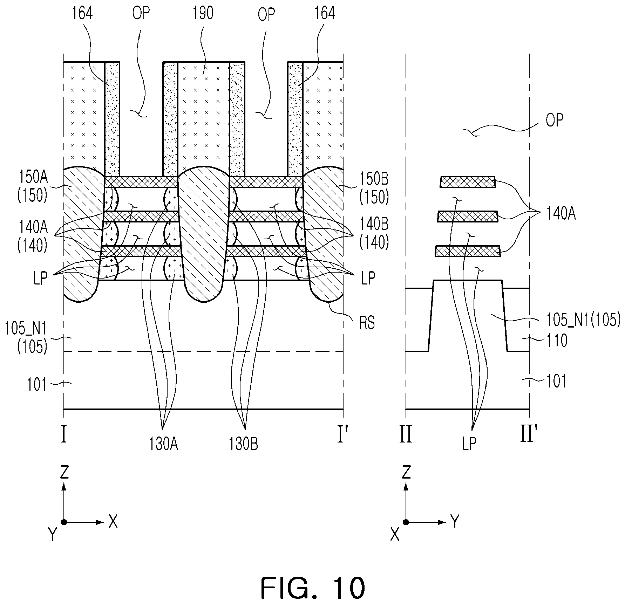

Referring to FIG. 10, an interlayer insulating layer 190 covering the source/drain regions 150 and the gate spacers 164 is formed, and the sacrificial gate patterns 170A and 170B and the sacrificial layers 120A and 120B are formed.

The sacrificial gate patterns 170A and 170B and the sacrificial layers 120A and 120B may be selectively removed with respect to the gate spacer 164, the channel layers 140, and the inner spacer layers 130. After the opening OP is formed by removing the sacrificial gate patterns 170A and 170B, the sacrificial layers 120A and 120B exposed through the opening OP may be removed to form gap regions LP.

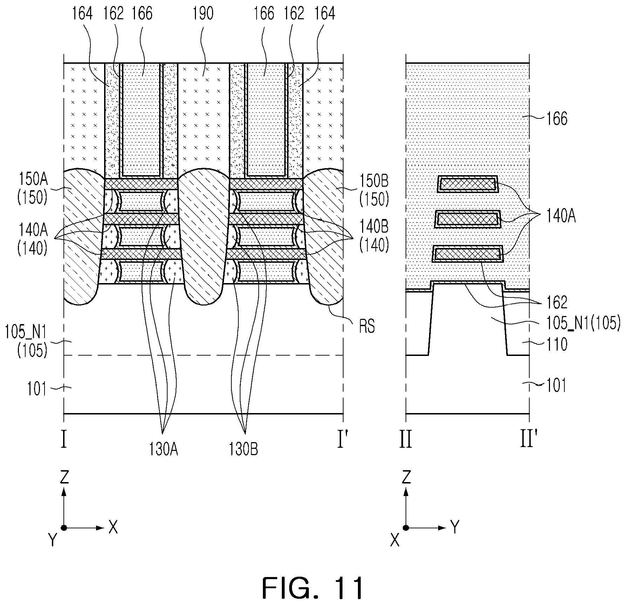

Referring to FIG. 11, a gate dielectric layer 162 and a gate electrode 166 may be formed.

The gate dielectric layer 162 may be conformally formed in the gap regions LP and the openings OP. The gate electrode 166 may be formed to completely fill the gap regions LP and the openings OP.

Next, referring to FIG. 3A, gate capping layers 168 and contact structures 180 may be formed. The gate capping layers 168 may be formed by partially etching the gate dielectric layer 162, the gate electrode 166, and the gate spacers 164, and then filling the insulating material with an insulating material. Accordingly, the gate structure 160 may be formed. The contact structures 180 may be formed in contact holes passing through the interlayer insulating layer 190 between the gate structures 160. The contact holes may partially recess the source/drain regions 150 at the bottom. A barrier layer 182 and a plug layer 184 may be formed by filling a conductive material in the contact holes. Before forming the barrier layer 182 and the plug layer 184, a metal-semiconductor compound layer 181 may be formed in the source/drain regions 150 exposed through the contact holes. Accordingly, the semiconductor device 100A of FIGS. 1 to 3B may be manufactured.

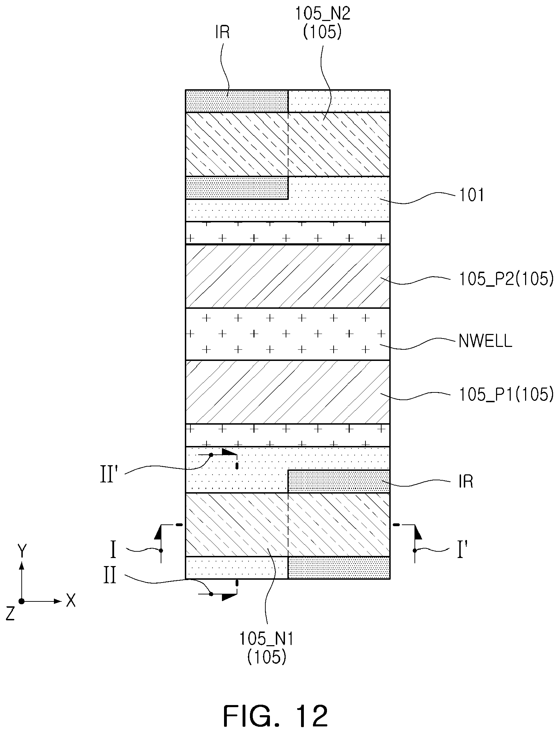

FIGS. 12 to 15 are views illustrating a process sequence to describe a method of manufacturing a semiconductor device according to example embodiments.

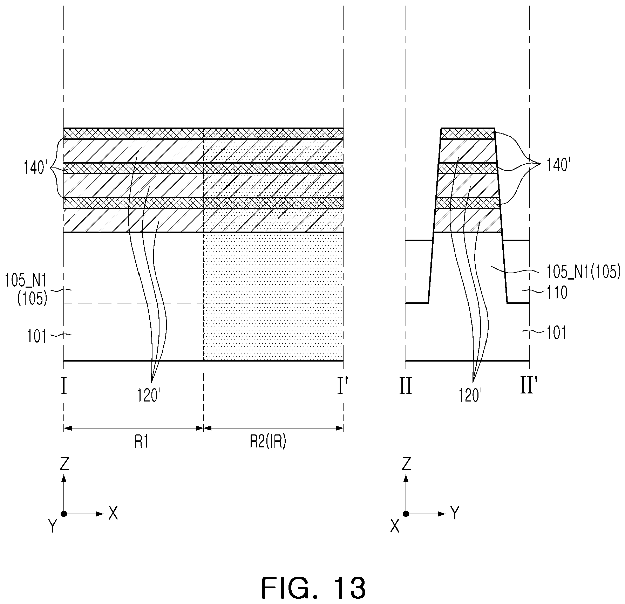

Referring to FIGS. 12 and 13, the doping region IR may be locally formed in a partial region of the substrate 101 on which the first active fin 105_N1 and the second active fin 105_N2 are disposed. The first semiconductor layers 120' and the second semiconductor layers 140' grown on the first region R1 are the first semiconductor layers 120 grown on the doped region IR of the second region R2and the second semiconductor layers 140' may have different impurity concentrations. For example, the first semiconductor layers 120' and the second semiconductor layers 140' grown on the doped region IR of the second region R2 may contain N-type or P type impurities having a higher concentration than that of the first region R1.

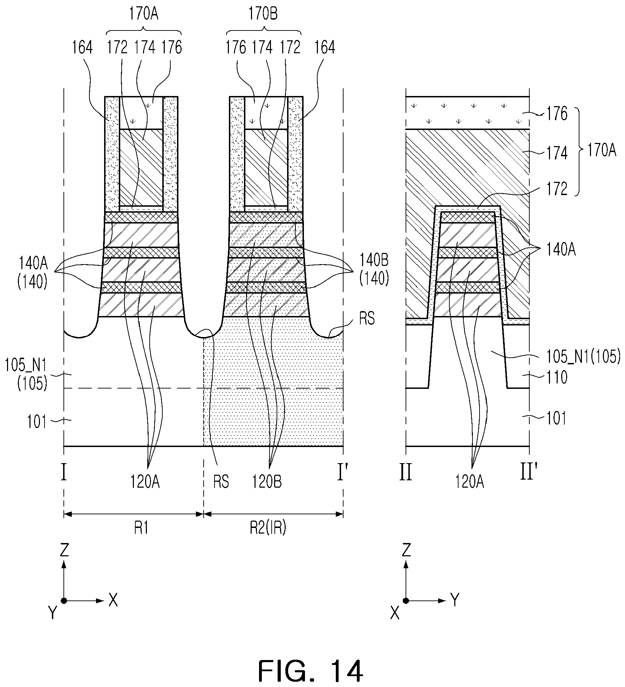

Referring to FIG. 14, the recess region RS recessing the active fin 105 may be formed by forming sacrificial gate patterns 170A and 170B and gate spacers 164 and etching the first semiconductor layers 120' and the second semiconductor layers 140'. Accordingly, the sacrificial layers 120A and 120B and the channel layers 140A and 140B may be formed.

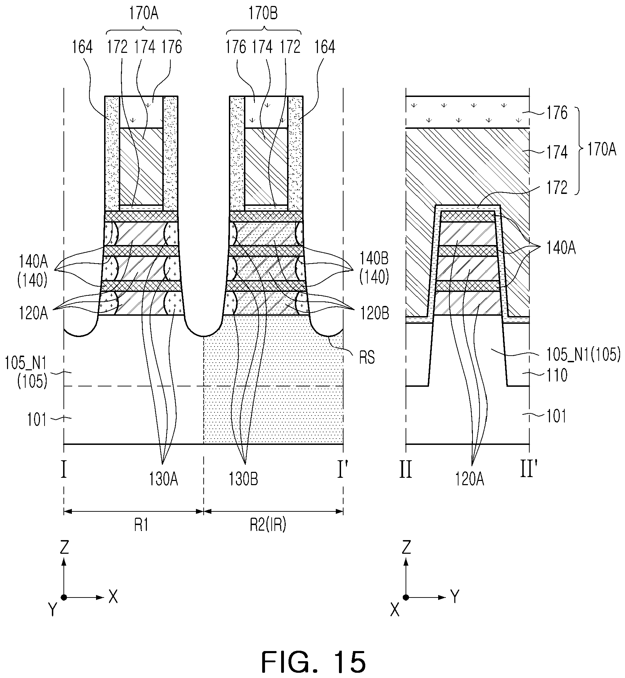

Referring to FIG. 15, some of the sacrificial layers 120A and 120B may be removed from side surfaces, and inner spacers 130A and 130B may be formed in regions from which the sacrificial layers 120A and 120B have been removed. The inner spacers 130A and 130B may be formed by filling an insulating material in the region from which the sacrificial layers 120A and 120B have been removed and by removing the insulating material deposited outside the channel layers 140A and 140B and below the recess region RS. Since the etching rate of the second sacrificial layers 120B is lower than that of the first sacrificial layers 120A, a small amount may be removed from the side surface. Accordingly, the second inner spacers 130B may be formed to have a smaller thickness in the X-direction than the first inner spacers 130A.

Next, after forming the source/drain regions 150 and the interlayer insulating layer 190, and removing the sacrificial gate patterns 170A and 170B and the sacrificial layers 120A and 120B, the gate dielectric layer 162 and the gate electrode 166 may be formed. Thereafter, gate capping layers 168 and contact structures 180 may be formed.

As set forth above, in the SRAM cell, as the length of the inner portion of the gate electrode of the pass-gate transistor is different from the length of the inner portion of the gate electrode of the pull-down transistor, a semiconductor device having improved electrical characteristics may be provided.

While aspects of example embodiments have been particularly shown and described above, it will be understood that various changes in form and details may be made therein without departing from the scope of the following claims.

## Claims

1. A semiconductor device (100A; 100B) comprising:
a substrate (101);
a static random-access memory, SRAM, cell comprising a pass-gate transistor (TA1), a pull-down transistor (TD1), and a pull-up transistor (TU1) on the substrate (101),
wherein each of the pass-gate transistor (TA1), the pull-down transistor (TD1), and the pull-up transistor (TU1) comprises:
an active fin (105) extending in a first direction (X) and protruding upwardly of a device isolation layer (110);
channel layers (140) disposed on the active fin (105) and spaced apart from each other;
a gate electrode (166) intersecting the active fin (105), extending in a second direction (Y), and surrounding the channel layers (140), the gate electrode (166) comprising inner portions (166iA, 166iB) disposed between the channel layers (140) and between the active fin (105) and a lowermost channel layer (141) among the channel layers (140);
a gate dielectric layer (162) disposed between the channel layers (140) and the gate electrode (166);
source/drain regions (150) disposed on the active fin (105) on both sides of the gate electrode (166), and connected to the channel layers (140); and
inner spacers (130) disposed between the inner portions of the gate electrode (166) and the source/drain regions (150),
wherein the inner spacers (130) of the pass-gate transistor (TA1) comprise first inner spacers (130A),
wherein the inner spacers (130) of the pull-down transistor (TD1) comprise second inner spacers (130B),
wherein at least portions of the first inner spacers (130A) disposed on different height levels have different thicknesses in the first direction (X),
wherein at least portions of the second inner spacers (130B) disposed on different height levels have different thicknesses in the first direction (X), and
wherein at least one of the first inner spacers (130A) and at least one of the second inner spacers (130B) are disposed at a same height level and have different thicknesses in the first direction (X).

2. The semiconductor device (100A; 100B) of claim 1, wherein the source/drain regions (150) comprise a shared source/drain region (150S),
wherein the channel layers (140) of the pass-gate transistor (TA1) comprise first channel layers (140A),
wherein the channel layers (140) of the pull-down transistor (TD1) comprise second channel layers (140B), and
wherein the shared source/drain region (150S) contacts the first channel layers (140A) and the second channel layers (140B).

3. The semiconductor device (100A; 100B) of claim 2, wherein the shared source/drain region (150S) contacts the first inner spacers (130A) and the second inner spacers (130B).

4. The semiconductor device (100A; 100B) of any one of claims 1 to 3, wherein the gate electrode (166) of the pass-gate transistor (TA1) comprises a first gate electrode (166A) having first inner portions (166iA),
wherein the gate electrode (166) of the pull-down transistor (TD1) comprises a second gate electrode (166B) having second inner portions (166iB), and
wherein at least one of the first inner portions (166iA) and at least one of the second inner portions (166iB) are disposed on the same height level as each other and have different gate lengths in the first direction (X).

5. The semiconductor device (100A; 100B) of any one of claims 1 to 4, wherein the first inner spacers (130A) include a first layer (131) having a first thickness in the first direction (X), a second layer (132) having a second thickness less than the first thickness in the first direction (X), and a third thickness less than the second thickness in the first direction (X), and
wherein the second inner spacers (130B) include a fourth layer (131) having a fourth thickness in the first direction (X), a fifth layer (132) having a fifth thickness less than the fourth thickness in the first direction (X), and a sixth layer (133) having a sixth thickness less than the fifth thickness in the first direction (X).

6. The semiconductor device (100A; 100B) of claim 5, wherein the first thickness is greater than the fourth thickness,
wherein the second thickness is greater than the fifth thickness, and
wherein the third thickness is greater than the sixth thickness.

7. The semiconductor device (100A; 100B) of claim 5, wherein the first thickness is less than the fourth thickness,
wherein the second thickness is less than the fifth thickness, and
wherein the third thickness is less than the sixth thickness.

8. The semiconductor device (100A; 100B) of any one of claims 1 to 7, wherein the inner spacers (130) have side surfaces that are curved and are convex toward the inner portions of the gate electrode (166).

9. The semiconductor device (100A; 100B) of any one of claims 1 to 8,
wherein the pass-gate transistor (TA1) and the pull-down transistor (TD1) are disposed adjacent to each other on the active fin (105) in the first direction (X),
wherein the gate electrode (166) of the pass-gate transistor (TA1) comprises a first gate electrode (166A),
wherein the source/drain regions (150) of the pass-gate transistor (TA1) comprises a first source/drain regions (150A, 150S),
wherein the inner spacers (130) of the pass-gate transistor (TA1) comprises a first inner spacers (130A),
wherein the gate electrode (166) of the pull-down transistor (TD1) comprises a second gate electrode (166B),
wherein the source/drain regions (150) of the pull-down transistor (TD1) comprises a second source/drain regions (150B, 150S), and
wherein the inner spacers (130) of the pull-down transistor (TD1) comprises a second inner spacers (130B).

10. The semiconductor device (100A; 100B) of claim 9, wherein the first inner portions (166iA) are disposed between the first inner spacers (130A), and
wherein the second inner portions (166iB) are disposed between the second inner spacers (130B).

11. The semiconductor device (100A; 100B) of claim 9 or 10, wherein at least one of the first source/drain regions (150A, 150S) of the pass-gate transistor (TA1) and at least one of the second source/drain regions (150B, 150S) of the pull-down transistor (TD1) is a shared source/drain region (150S).

12. The semiconductor device (100A; 100B) of any one of claims 9 to 11, wherein the first source/drain regions (150A, 150S) project into recesses in the active fin (105) to a position lower than a top of the active fin (105), and
wherein the second source/drain regions (150B, 150S) project into recesses in the active fin (105) to a position lower than the top of the active fin (105).

13. The semiconductor device (100A; 100B) of any one of claims 9 to 12, wherein an uppermost first inner spacer among the first inner spacers (130A) contacts a lower surface of an uppermost first channel layer among the first channel layers (140A), and
wherein an uppermost second inner spacer among the second inner spacers (130B) contacts a lower surface of an uppermost second channel layer among the second channel layers (140B).

14. The semiconductor device (100A; 100B) of claim 13, wherein the uppermost first inner spacer has a first thickness (t3a) in the first direction (X),
wherein the uppermost second inner spacer has a second thickness (t3b) in the first direction (X), and
wherein the first thickness (t3a) is greater than the second thickness (t3b).

15. The semiconductor device (100A; 100B) of any one of claims 1 to 8,
wherein the pass-gate transistor (TA1) and the pull-down transistor (TD1) are disposed adjacent to each other in the first direction (X) on the active fin (105),
wherein the gate electrode (166) of the pass-gate transistor (TA1) comprises a first gate electrode (166A),
wherein the gate dielectric layer (162) of the pass-gate transistor (TA1) comprises a first gate dielectric layer,
wherein the source/drain regions (150) of the pass-gate transistor (TA1) comprises a first source/drain regions (150A, 150S),
wherein the inner spacers (130) of the pass-gate transistor (TA1) comprises a first inner spacers (130A),
wherein the gate electrode (166) of the pull-down transistor (TD1) comprises a second gate electrode (166B),
wherein the gate dielectric layer (162) of the pull-down transistor (TD1) comprises a second gate dielectric layer,
wherein the source/drain regions (150) of the pull-down transistor (TD1) comprises a second source/drain regions (150B, 150S),
wherein the inner spacers (130) of the pull-down transistor (TD1) comprises a second inner spacers (130B),
wherein the first gate electrode (166A) comprises first inner portions (166iA) between the first inner spacers (130A),
wherein the second gate electrode (166B) comprises second inner portions (166iB) between the second inner spacers (130B), and
wherein at least one of the first inner portions (166iA) and at least one of the second inner portions (166iB) are disposed on the same height level as each other and have different gate lengths in the first direction.
